# FASCICULE DE BREVET EUROPEEN

(11) **EP 2 174 536 B1**
(45) Date de publication et mention de la délivrance du brevet: **13.08.2014**
(21) Numéro de dépôt: 08805888.8
(22) Date de dépôt: 29.05.2008
(51) Int. Cl.: H01R 12/52, H05K 7/14

(54) **EQUIPEMENT AVIONIQUE**
FLUGZEUGAUSRÜSTUNG
AVIONICS EQUIPMENT

(30) Priorité: 21.06.2007 FR 0755921
(43) Date de publication de la demande: 14.04.2010
(73) Titulaire: Airbus Operations, 31060 Toulouse (FR)
(72) Inventeur: ORTET, Stéphane, F-31700 Mondonville (FR)
(74) Mandataire: Bonnans, Arnaud
(86) Numéro de dépôt international: PCT/FR2008/050945
(87) Numéro de publication internationale: WO 2008/155498

(56) Documents cités:
- FR-A- 2 783 392
- US-A- 4 131 933
- US-A- 5 234 348
- US-A- 5 348 482
- US-B1- 6 512 676
- US-B1- 7 180 751

## Description

La présente invention concernant un équipement avionique. Elle s'applique, en particulier, aux calculateurs embarqués.

Lors du développement de calculateurs embarqués destinés à des aéronefs de grandes dimensions, les contraintes en vibrations sont particulièrement importantes.

L'assemblage des cartes fond de panier est réalisé, dans certaines applications par exemple ARINC 600, par de simples entretoises qui lient la carte mère à la carte fond de panier et qui lient l'ensemble fond de panier à la face arrière de l'équipement.

Il existe deux grandes familles de solutions pour concevoir un équipement comportant, dans un boîtier, une carte mère et des cartes filles. Dans la première, on met en oeuvre des glissières non verrouillables : une carte fille coulisse dans un guide lié au boîtier et elle est immobilisée en partie par la force de rétention des contacts des connecteurs de la carte mère et, éventuellement, par des éléments de maintien en face avant (mousse, vis, ...). Ces solutions sont adaptées à des environnements vibratoires peu contraignants.

Dans la deuxième famille de solutions, on met en oeuvre des glissières à verrouillage : la carte coulisse dans un guide lié au boîtier et est immobilisée par un système mécanique qui la solidarise avec le boîtier. Ces solutions sont adaptées à des environnements vibratoires plus contraignants. Cependant, les cartes étant attachées de manière rigide en partie haute et basse de l'équipement, en vibrations, les efforts générées par la masse des cartes transitent par la paroi externe de l'équipement pour être « repris » par le connecteur « Arinc » (acronyme de « Aeronautical Radio, Incorporated », marque déposée) qui réalise la fixation de l'équipement sur l'avion. Les parois n'étant pas infiniment rigides, toute la zone arrière de l'équipement se déforme (en particulier la face arrière) ce qui crée un mouvement relatif entre le bloc constitué des cartes électroniques et le fond de panier. A ces inconvénients s'ajoutent des déformations importantes au sein même du fond de panier.

Or les connecteurs, qui sont les éléments qui réalisent la liaison électrique entre les sous-ensembles sont sensibles à ces déformations. Les sous-ensembles se déplaçant de manière relative entre eux, il se crée des micros déplacements entre les parties male et femelle des connecteurs, ce qui induit des risques d'usures, connues sous le nom de « Fretting corosion ».

US 534848 montre un équipment avionique selon le préambule de la revendication 1.

La façon classique de résoudre ces problèmes est d'utiliser de la connectique robuste en vibration. Cette connectique, empruntée au marché militaire, provenant d'un marché étroit, est très onéreuse.

La présente invention vise à remédier à ces inconvénients et, notamment, à limiter le mouvement relatif entre les cartes filles et la carte mère et à limiter la déformation de la partie arrière de l'équipement.

A cet effet, la présente invention vise un équipement avionique comportant une carte mère, au moins une carte fille et, pour chaque carte fille, deux supports en forme de glissière fixés directement sur la carte mère et supportant ladite carte fille.

Grâce à ces dispositions, on réduit les mouvements relatifs au niveau des connecteurs entre la carte mère et chaque carte fille. Selon des caractéristiques particulières, l'équipement avionique tel que succinctement exposé ci-dessus comporte deux pièces mécaniques, supérieure et inférieure, respectivement, comportant, chacune, l'un des supports en forme de glissière de chaque carte fille.

Grâce à ces dispositions, la rigidité du montage est encore renforcée.

Selon des caractéristiques particulières, l'équipement avionique tel que succinctement exposé ci-dessus comporte au moins une pièce mécanique de liaison entre la carte mère et une carte fond de panier reliée à un connecteur d'avionique. On note que ce connecteur d'avionique est généralement connu sous le nom de connecteur « Arinc ».

Selon des caractéristiques particulières, au moins une pièce mécanique de liaison entre la carte mère et une carte fond de panier comporte, en outre, des moyens de fixation de la face arrière de l'équipement avionique.

Selon des caractéristiques particulières, au moins une pièce mécanique de liaison entre la carte mère et une carte fond de panier comporte, en outre, des moyens de fixation du connecteur d'avionique.

Selon des caractéristiques particulières, au moins une pièce mécanique de liaison entre la carte mère et une carte fond de panier comporte, en outre, des moyens de fixation de la face arrière de l'équipement avionique et des moyens de fixation du connecteur d'avionique.

Selon des caractéristiques particulières, l'équipement avionique tel que succinctement exposé ci-dessus comporte au moins une pièce mécanique de liaison entre la carte mère et le connecteur d'avionique.

Selon des caractéristiques particulières, au moins une pièce mécanique de liaison entre la carte mère et le connecteur d'avionique comporte, en outre, des moyens de fixation de la face arrière de l'équipement avionique.

Selon des caractéristiques particulières, l'équipement avionique tel que succinctement exposé ci-dessus comporte au moins une pièce mécanique de liaison entre la carte mère et la face arrière de l'équipement avionique.

Grâce à chacune de ces dispositions, on réduit considérablement les déplacements dans la zone fond de panier.

D'autres avantages, buts et caractéristiques de la présente invention ressortiront de la description qui va suivre, faite, dans un but explicatif et nullement limitatif en regard des dessins annexés, dans lesquels :
- la figure 1 représente, en perspective, un mode de réalisation particulier de l'équipement avionique objet de la présente invention,
- la figure 2 représente, en perspective, un détail du mode de réalisation particulier de l'équipement avionique illustré en figure 1,
- la figure 3 représente, en coupe, l'équipement avionique illustré en figure 1,
- la figure 4 représente, agrandie, une partie de l'équipement avionique des figures 1 à 3,
- les figures 5A et 5B représentent, en perspective, selon deux vues d'orientations opposées, une forme particulière de réalisation d'un moyen de fixation supérieur du mode de réalisation particulier des figures 1 à 4 et
- la figure 6 représente, en perspective, une forme particulière de réalisation d'un moyen de fixation inférieur du mode de réalisation particulier des figures 1 à 4.

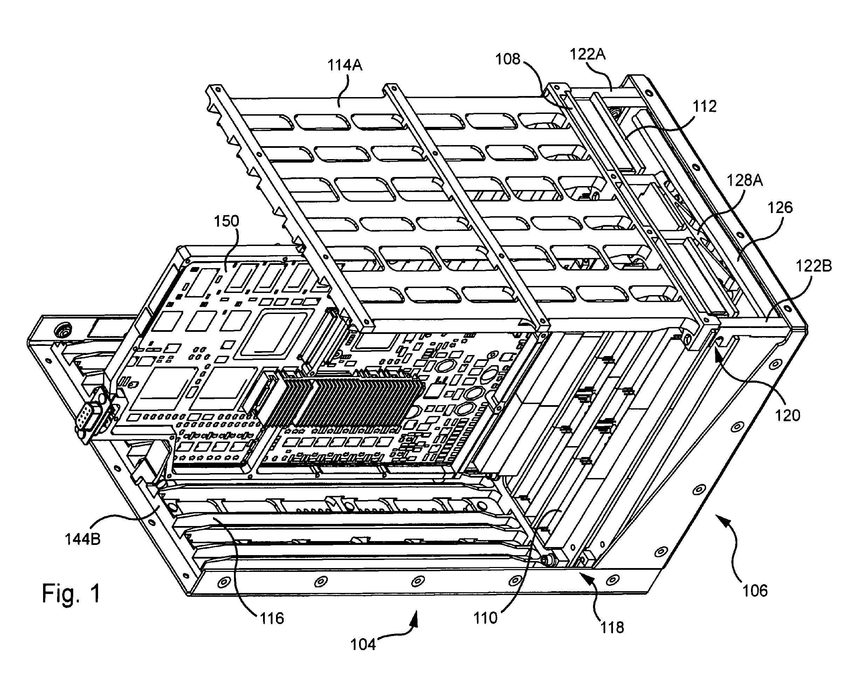

On observe, dans les figures, un équipement avionique 102 comportant une face inférieure 104, une face arrière 106, une carte mère 108, des emplacements 110 pour sept cartes filles 150 (une seule étant représentée en figure 1) et une carte fond de panier 112 reliée à un connecteur avionique 124.

Dans un but de clarté, les autres faces de l'équipement avionique 102, c'est-à-dire les faces latérales, arrière et supérieure ne sont pas représentées dans les figures.

On observe aussi, dans les figures, un support glissière inférieur 114B de cartes filles 150, comportant, pour chaque carte fille, une glissière 116, zone du support formant un « U » qui accueille la carte fille 150 et, éventuellement, un cadre carte qui supporte la glissière à verrouillage (pièce mécanique complexe qui s'expanse) qui réalise une fonction de blocage.

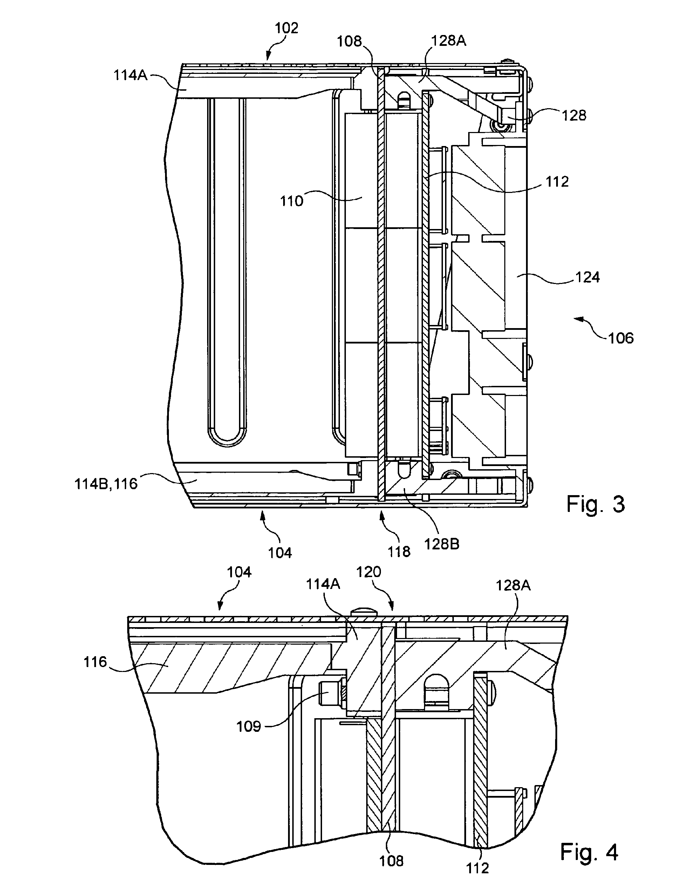

Comme on le voit plus précisément en regard de la figure 4, le support 114B est directement fixé sur la partie basse 118 de carte mère 108 et est adapté à supporter chacune des cartes filles 150 de l'équipement avionique 102.

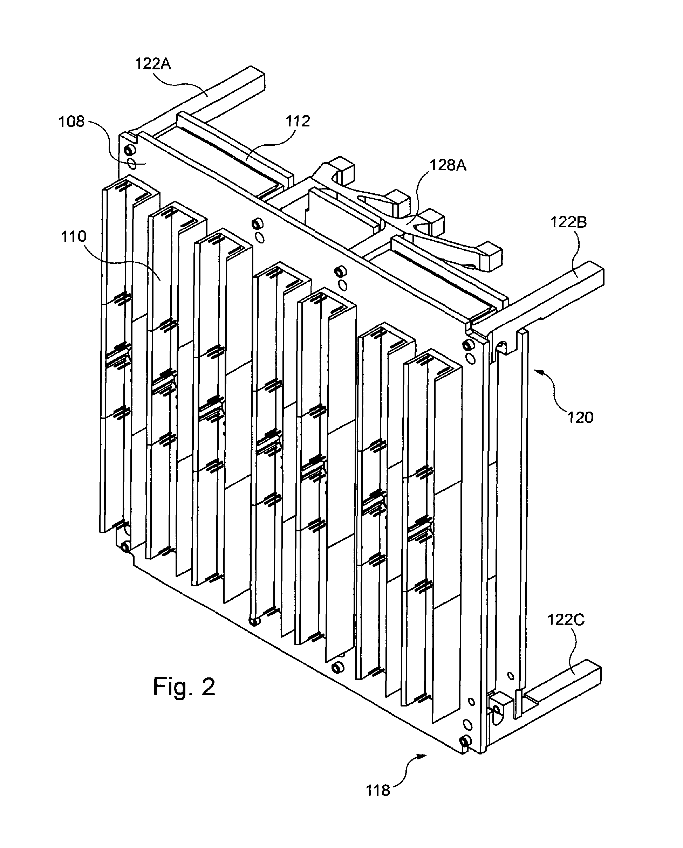

Dans un but de clarté, on n'a pas représenté, dans les figures 2 et 3, un support supérieur 114A, symétrique du support inférieur 114B, ce support supérieur 114A étant relié à la partie haute 120 de la carte mère 108 de la même manière que le support 114B. Ce support supérieur.114A comporte, lui aussi, pour chaque carte fille 150, une glissière 116. Le support supérieur 114A est ainsi adapté à supporter chacune des cartes filles de l'équipement avionique 102.

Dans le mode de réalisation illustré dans les figures, ce ne sont, ainsi que deux supports, respectivement supérieur et inférieur, qui comportent, chacun, l'une des glissières 116 de maintien de chaque carte fille. Dans des variantes, plusieurs supports supérieurs et plusieurs supports inférieurs, tous fixés directement sur la carte mère 108, comportent, chacun, au moins une glissière de maintien 116 de carte fille.

On observe, dans les figures 1 et 2, respectivement deux et trois pièces mécaniques 122A à 122C de liaison entre la carte mère 108 et la carte fond de panier 112. Une quatrième pièce mécanique de liaison 122D se trouve en partie basse 118 de la carte mère 108 mais n'est pas visible dans les figures. Dans les figures, ces pièces mécaniques de liaison 122A à 122D prennent la forme d'entretoises droites. Ces pièces mécaniques de liaison 122A à 122D comportent, en outre, des moyens de fixation à la face arrière 106 de l'équipement avionique 102.

On observe aussi, en figure 1, un renfort 126 de face arrière 106, élongée horizontalement sur la surface interne de la face arrière 106, en partie haute et de section en forme de « L ».

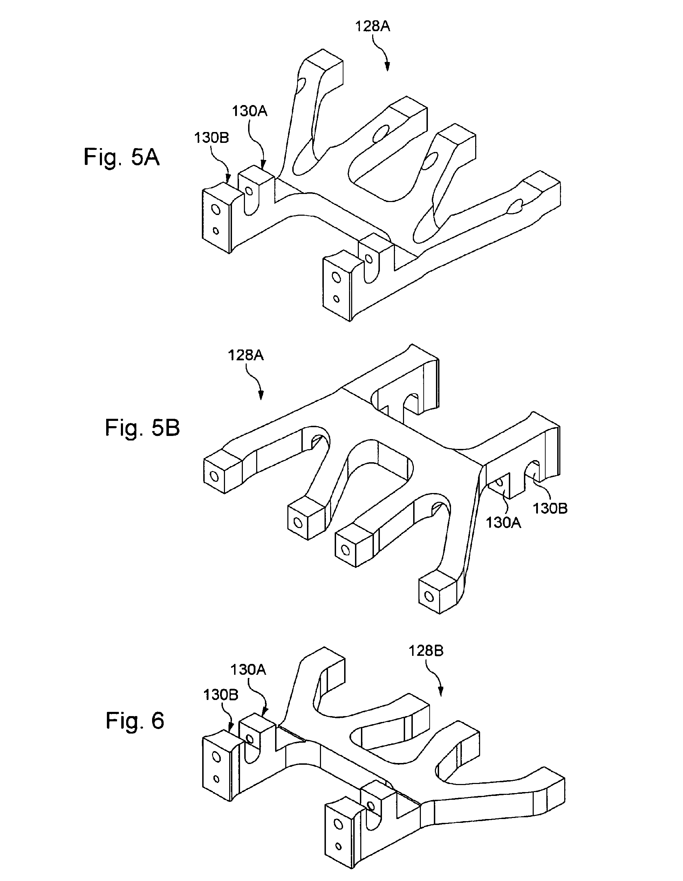

On observe dans les figures des moyens de fixation supérieur 128A et inférieur 128B du connecteur d'avionique 124. Dans les figures, ces moyens de fixation 128A et 128B, illustrés en figures 5A, 5B et 6, prennent la forme d'entretoises coudées.

Préférentiellement, les moyens de fixation 128A et 128B sont, chacune, une pièce unique qui fait la liaison entre les éléments suivants : la carte mère, la deuxième carte fond de panier, le connecteur d'avionique Arinc (de manière prioritaire car c'est la liaison avec l'avion) et la face arrière.

Préférentiellement aussi, comme dans les modes de réalisation illustrés dans les figures, les mêmes pièces mécaniques 122A à 122D assurent la liaison entre la carte mère et la carte fond de panier, la liaison de la carte mère avec la face arrière de l'équipement avionique, la liaison de la carte fond de panier avec la face arrière de l'équipement avionique. Cependant, dans d'autres modes de réalisation, ces différentes fonctions sont réalisées par plusieurs pièces mécaniques différentes, selon les différentes combinaisons possibles de ces fonctions et/ou ces pièces assurent, en outre, la fonction de fixation de connecteur d'avionique.

Comme illustré en figure 3, le support inférieur 114B est aligné avec chaque entretoise inférieure 122C et 122D et avec le moyen de fixation inférieur 128B, la partie basse 118 de carte mère 108 étant maintenue entre le support 114B, d'une part, et les entretoises inférieures 122C et 122D et moyen de fixation inférieur 128B, d'autre part, par des boulons 109. On note qu'en figure 3, le support supérieur 114A n'a pas été représenté.

Comme illustré en figure 4, le support supérieur 114A est aligné avec chaque entretoise supérieure 122A et 122B et avec le moyen de fixation supérieur 128A, la partie haute 120 de carte mère 108 étant maintenue entre le support 114A, d'une part, et les entretoises supérieures 122A et 122B et le moyen de fixation supérieur 128A, d'autre part, par des boulons 109.

De plus, comme illustré en figures 4, 5A, 5B et 6, les entretoises supérieures et inférieures 122A à 122D et les moyens de fixation 128A et 128B comportent des surfaces planes 130A et 130B perpendiculaires à l'élongation principale de ces pièces, pour supporter, d'une part, la carte mère 108, comme expliqué ci-dessus et, d'autre part, la carte fond de panier 112, chaque boulon 109 traversant ces deux cartes 108 et 112, et, entre elles, deux parties des moyens de fixation 128.

Comme on le comprend à la lecture de la description ci-dessus, la mise en oeuvre de la présente invention permet l'utilisation d'une connectique « industrielle » performante en termes de tenue aux vibrations, en termes de densité de points et en termes de coût. Elle permet de limiter le mouvement relatif entre les cartes filles et la carte mère. Elle permet aussi de limiter la déformation de la partie arrière de l'équipement en rigidifiant la liaison entre la carte mère et la carte fond de panier ainsi que la liaison entre cet ensemble et le connecteur d'avionique Arinc.

En particulier, le montage direct des supports de cartes filles en forme de glissière sur la carte mère limite considérablement les mouvements relatifs au niveau de la connectique cartes filles / carte mère.

## Revendications

1. Equipement avionique comportant une carte mère (108), au moins une carte fille (150) et pour chaque carte fille, deux supports (116) en forme de glissière fixés directement sur la carte mère et supportant ladite carte fille, **caractérisé en ce qu'**il comporte, en outre, au moins une pièce mécanique de liaison (128A, 128B) assurant chacune la liaison entre la carte mère (108) et
- d'une part, une carte fond de panier (112) reliée à un connecteur d'avionique (124),
- et, d'autre part, un connecteur d'avionique (124), ledit connecteur d'avionique réalisant la fixation de l'équipement sur un avion,

2. Equipement avionique selon la revendication 1, **caractérisé en ce qu'**il comporte des boulons (109) traversant la carte mère et la carte de fond de panier, et, entre ces cartes, deux parties d'une dite pièce mécanique (128A, 128B).

3. Equipement avionique selon l'une quelconque des revendications 1 ou 2, **caractérisé en ce qu'**il comporte deux pièces mécaniques (114A, 114B), respectivement supérieure et inférieure, comportant, chacune, l'un des supports (116) en forme de glissière de chaque carte fille (150).

4. Equipement avionique selon l'une quelconque des revendications 1 à 3, **caractérisé en ce qu'**au moins une pièce mécanique de liaison (128A, 128B) entre la carte mère (108) et une carte fond de panier (112) comporte, en outre, des moyens de fixation de la face arrière (106) de l'équipement avionique.

5. Equipement avionique selon la revendication 4, **caractérisé en ce qu'**au moins une pièce mécanique de liaison (128A, 128B) entre la carte mère (108) et une carte fond de panier (112) comporte, en outre, des moyens de fixation du connecteur d'avionique (124).

6. Equipement avionique selon l'une quelconque des revendications 4 ou 5, **caractérisé en ce qu'**au moins une pièce mécanique de liaison (128A, 128B) entre la carte mère (108) et une carte fond de panier (112) comporte, en outre, des moyens de fixation de la face arrière (106) de l'équipement avionique et des moyens de fixation du connecteur d'avionique (124).

7. Equipement avionique selon la revendication 1, **caractérisé en ce qu'**au moins une pièce mécanique de liaison (128A, 128B) entre la carte mère (108) et un connecteur d'avionique (124) comporte, en outre, des moyens de fixation de la face arrière (106) de l'équipement avionique.

8. Equipement avionique selon l'une quelconque des revendications 1 à 7, **caractérisé en ce qu'**il comporte au moins une unique pièce mécanique de liaison (, 128A, 128B) qui assure également la liaison entre la carte mère (108) et la face arrière (106) de l'équipement avionique.

9. Equipement avionique selon la revendication 8, **caractérisé en ce que** ladite au moins une pièce mécanique de liaison (128A, 128B) prend la forme d'une entretoise coudée.

10. Equipement avionique selon l'une quelconque des revendications 8 ou 9, **caractérisé en ce que** ladite au moins une pièce mécanique de liaison (128A, 128B) comporte, d'une part, des surfaces (130A,130B), perpendiculaires à l'élongation, fixées respectivement à la carte mère (108) et à la carte de fond de panier (112) et, d'autre part, une élongation oblique, qui s'étend par rapport à l'élongation principale, la carte mère (108) et au fond de panier, et qui est reliée à au moins un connecteur d'avionique (124).

## Patentansprüche

1. Flugzeugausrüstung, enthaltend eine Mutterplatine (108), zumindest eine Tochterplatine (150) und für jede Tochterplatine zwei Halterungen (116) in Form von Gleitführungen, die direkt an die Mutterplatine befestigt sind und die Tochterplatine halten, **dadurch gekennzeichnet, dass** sie ferner zumindest ein mechanisches Verbindungsteil (128A, 128B) aufweist, das jeweils die Verbindung zwischen der Mutterplatine (108) und
- einer mit einem Flugzeugverbinder (124) verbundenen Rückwandplatine (112) einerseits
- und einem Flugzeugverbinder (124) andererseits gewährleistet, wobei der Flugzeugverbinder die Befestigung der Ausrüstung an einem Flugzeug sicherstellt.

2. Flugzeugausrüstung nach Anspruch 1, **dadurch gekennzeichnet, dass** sie Bolzen (109) aufweist, die sich durch die Mutterplatine und die Rückwandplatine erstrecken, sowie zwischen diesen Platinen zwei Abschnitte des einen mechanischen Teils (128A, 128B).

3. Flugzeugausrüstung nach einem der Ansprüche 1 oder 2, **dadurch gekennzeichnet, dass** sie zwei mechanische Teile (114A, 114B), nämlich ein oberes und ein unteres, aufweist, die jeweils eine der Halterungen (116) in Form von Gleitführungen einer jeden Tochterplatine (150) aufweisen.

4. Flugzeugausrüstung nach einem der Ansprüche 1 bis 3, **dadurch gekennzeichnet, dass** zumindest ein mechanisches Verbindungsteil (128A, 128B) zwischen der Mutterplatine (108) und einer Rückwandplatine (112) ferner Mittel zum Befestigen der Rückseite (106) der Flugzeugausrüstung aufweist.

5. Flugzeugausrüstung nach Anspruch 4, **dadurch gekennzeichnet, dass** zumindest ein mechanisches Verbindungsteil (128A, 128B) zwischen der Mutterplatine (108) und einer Rückwandplatine (112) ferner Mittel zum Befestigen des Flugzeugverbinders (124) aufweist.

6. Flugzeugausrüstung nach einem der Ansprüche 4 oder 5, **dadurch gekennzeichnet, dass** zumindest ein mechanisches Verbindungsteil (128A, 128B) zwischen der Mutterplatine (108) und einer Rückwandplatine (112) ferner Mittel zum Befestigen der Rückseite (106) der Flugzeugausrüstung und Mittel zum Befestigen des Flugzeugverbinders (124) aufweist.

7. Flugzeugausrüstung nach Anspruch 1, **dadurch gekennzeichnet, dass** zumindest ein mechanisches Verbindungsteil (128A, 128B) zwischen der Mutterplatine (108) und einem Flugzeugverbinder (124) ferner Mittel zum Befestigen der Rückseite (106) der Flugzeugausrüstung aufweist.

8. Flugzeugausrüstung nach einem der Ansprüche 1 bis 7, **dadurch gekennzeichnet, dass** sie zumindest ein einziges mechanisches Verbindungsteil (128A, 128B) aufweist, das auch die Verbindung zwischen der Mutterplatine (108) und der Rückseite (106) der Flugzeugausrüstung sicherstellt.

9. Flugzeugausrüstung nach Anspruch 8, **dadurch gekennzeichnet, dass** das zumindest eine mechanische Verbindungsteil (128A, 128B) die Form einer gekröpften Strebe annimmt.

10. Flugzeugausrüstung nach einem der Ansprüche 8 oder 9, **dadurch gekennzeichnet, dass** das zumindest eine mechanische Verbindungsteil (128A, 128B) einerseits Flächen (130A, 130B) aufweist, die senkrecht zum Fortsatz verlaufen und an die Mutterplatine (108) bzw. an die Rückwandplatine (112) befestigt sind, sowie andererseits einen schräg verlaufenden Fortsatz, der sich im Verhältnis zum Hauptfortsatz, zur Mutterplatine (108) und zur Rückwandplatine erstreckt und der mit zumindest einem Flugzeugverbinder (124) verbunden ist.

## Claims

1. Avionic equipment item comprising a motherboard (108), at least one daughterboard (150) and for each daughterboard, two supports (116) in the form of a slide fastened directly onto the motherboard and supporting the said daughterboard, wherein it furthermore comprises at least one mechanical connecting part (128A, 128B) each mechanical connecting part connecting the motherboard (108) and :
- a backplane board (112) connected to an avionic connector (124), and
- an avionic connector (124), said avionic connector fastening the avionic equipment item to a plane.

2. Avionic equipment item according to claim 1, wherein it comprises bolts (109) going through the motherboard and the backplane board, and, between said boards, two sections of a said mechanical connecting part (128A, 128B).

3. Avionic equipment item according any one of claims 1 to 2, wherein it comprises two mechanical parts (114A, 114B), upper and lower respectively, each comprising one of the supports (116) in the form of a slide for each daughterboard (150).

4. Avionic equipment item according to anyone of claims 1 to 3, wherein at least one mechanical connecting part (128A, 128B) between the motherboard (108) and a backplane board (112) furthermore comprises fastening means for the rear face (106) of the avionic equipment item.

5. Avionic equipment item according to claim 4, wherein at least one mechanical connecting part (128A, 128B) between the motherboard (108) and a backplane board (112) furthermore comprises fastening means for the avionic connector (124).

6. Avionic equipment item according to any one of claims 4 to 5, wherein at least one mechanical connecting part (128A, 128B) between the motherboard (108) and a backplane board (112) furthermore comprises fastening means for the rear face (106) of the avionic equipment item and fastening means for the avionic connector (124).

7. Avionic equipment item according to claim 1, wherein at least one mechanical connecting part (128A, 128B) between the motherboard (108) and an avionic connector (124) furthermore comprises fastening means for the rear face (106) of the avionic equipment item.

8. Avionic equipment item according to any one of claims 1 to 7, wherein it comprises at least a single mechanical connecting part (128A, 128B) which also connects the motherboard (108) and the rear face (106) of the avionic equipment item.

9. Avionic equipment item according to claim 8, wherein said at least mechanical connecting part (128A, 128B) has the shape of a bent crosspiece.

10. Avionic equipment item according to any one of claims 8 to 9, wherein said at least one mechanical connecting part (128A, 128B) comprises, on the one hand, surfaces (130A, 130B) that are perpendicular to the extension, and respectively fastened to the motherboard (108) and the backplane board (112), and, on the other hand, a slanted extension which stretches out from the main extension, the motherboard (108) and the backplane, and is connected to at least an avionic connector (124).
